# EUROPEAN PATENT APPLICATION

(11) **EP 1 296 334 A2**
(43) Date of publication of application: **26.03.2003**
(21) Application number: 02250682.8
(22) Date of filing: 31.01.2002
(51) Int. Cl.: G11C 15/00, G11C 15/04

(54) **Associative memory with matching circuit with differential amplification**

(30) Priority: 25.09.2001 JP 2001290891
(71) Applicant: FUJITSU LIMITED, Kawasaki-shi, Kanagawa 211-8588 (JP)
(72) Inventor: Aikawa, Tadao, c/o Fujitsu Limited, Kuwasaki-shi, Kanagawa 211-8588 (JP)
(74) Representative: Stebbing, Timothy Charles

(57) **Abstract**

This associative memory circuit comprises a plurality of logic circuits connected to a common match line (12). Each of the logic circuits (Q1-Q4) compares a content stored in each of a plurality of memory cells (10₁, 10₂, ...) with externally supplied search data so as to output a comparison result thereof to the match line (12). The associative memory circuit also comprises a reference-potential producing circuit (22) provided correspondingly for the match line (12) so as to produce a reference potential used in relation with the match line (12), and a differential amplifier circuit (20) performing a differential amplification to a potential of the match line (12) and the reference potential so as to judge whether or not the content matches the search data.

## Description

### BACKGROUND OF THE INVENTION

### 1. Field of the Invention

The present invention generally relates to an associative memory circuit and, more particularly, to an associative memory circuit which is capable of referring to memory data.

### 2. Description of the Related Art

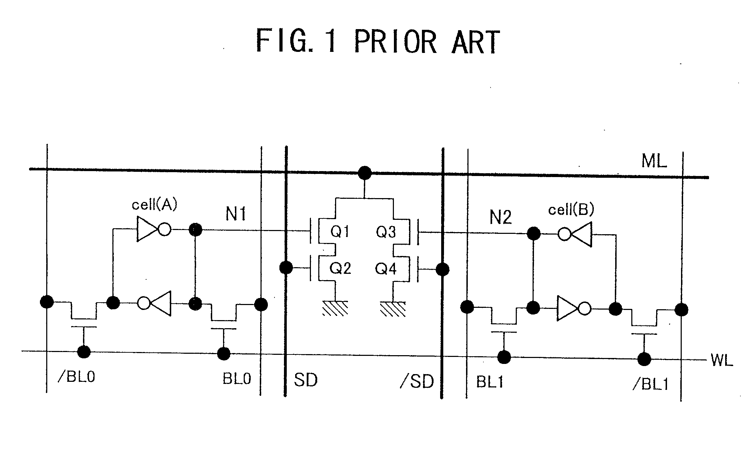

One of characteristic operations of a CAM (Content Addressable Memory), i.e., an associative memory, is a search, i.e., retrieval operation. This search operation is an operation comparing externally supplied data with data in a CAM cell. In order to perform this search operation, the CAM cell has a structure as shown in FIG.1.

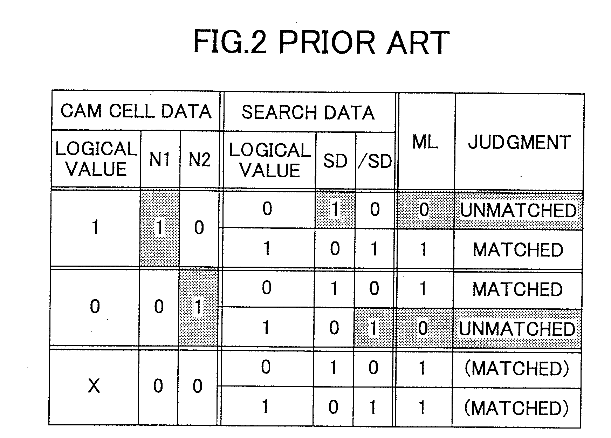

Either of conditions "1", "0" or "X (inconstant)" is stored in two partial cells A and B shown in FIG.1, each of the partial cells A and B comprising two inverters. FIG.2 shows a truth table of this CAM cell. The condition "1" is stored in the partial cells A and B with an output N1 of the partial cell A being "H (1)" and an output N2 of the partial cell B being "L (0)". The condition "0" is stored in the partial cells A and B with the output N1 being "L (0)" and the output N2 being "H (1)". The condition "X" is stored in the partial cells A and B with both the outputs N1 and N2 being "L (0)".

Search data (SD, /SD) of the search operation valued "H (1)" or "L (0)" is supplied to this CAM cell, and is compared with data stored in the CAM cell. When N-channel FETs (Field-Effect Transistors) Q1 and Q2, or Q3 and Q4 turn on simultaneously, a level of an ML (Match Line) drops so as to indicate that the search data (SD, /SD) does not match the data stored in the CAM cell. It is noted that a slash (/) used before SD means "inverse", and the same goes for other signals.

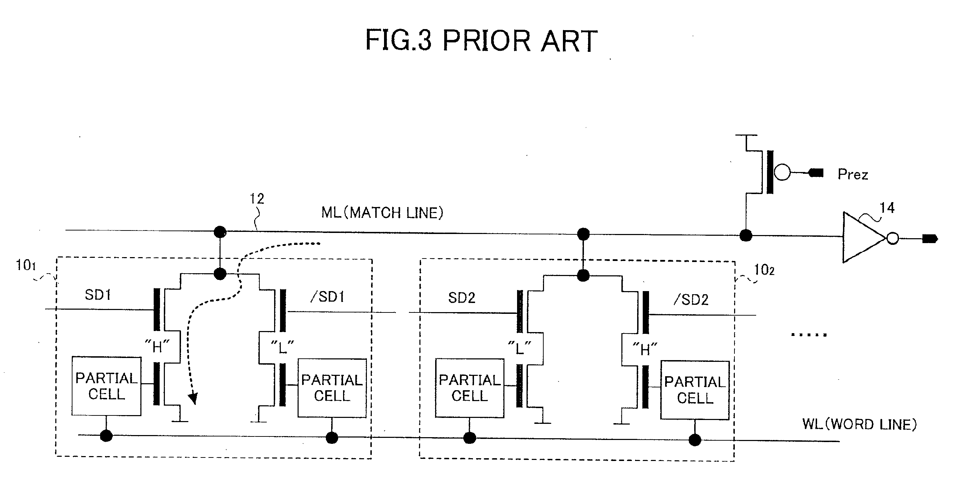

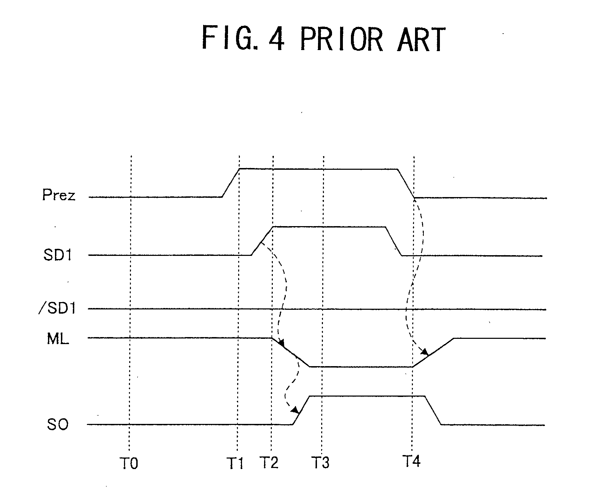

Next, a description will be given, with reference to FIG.3 and FIG.4, of a search operation in respect to one ML (Match Line). FIG.3 is a circuit diagram of a conventional associative memory circuit. FIG.4 shows signal waveforms at parts of the conventional associative memory circuit shown in FIG.3. In FIG.3, each of CAM cells 10₁, 10₂, ..., surrounded by broken lines, has the structure shown in FIG.1. In an actual chip arrangement, these CAM cells 10₁, 10₂, ... are wired in an OR-connection by an ML (Match Line) 12.

As indicated by the signal waveforms shown in FIG.4, in a standby state at a time T0 before the search operation, a precharge signal (Prez) is "L" so that the ML 12 is charged with "H". The search operation begins by a precharge cancellation at a time T1. At the time T1, the precharge of the ML is cancelled, and thereafter, search data SD is transmitted to the CAM cell.

In this state, the search data SD is compared with data stored in the CAM cell. When both the data stored in the CAM cell and the search data SD are "H", an electric charge is discharged from the ML 12 (at a time T3). As mentioned above, the CAM cells are wired in the OR-connection. Therefore, when both the data stored in the CAM cell and the search data SD are "H" so that even one of the CAM cells is discharged, the ML 12 becomes "L" so as to indicate that the search data SD does not match the data stored in the CAM cell.

According to the state transition of the ML 12, the search result is output as a signal SO via an inverter amplifier 14. At a time T4, when the precharge signal (Prez) transits to "L" so that the ML 12 is precharged with "H", one cycle of the search operation ends.

In order to provide a multiple-bit, high-capacity CAM in a conventional circuit while maintaining a small chip area, it is conceivable to increase the number of CAM cells wired in the OR-connection. However, this also increases the load of the ML so that the transition rate of the ML becomes lower. Since the low transition rate of the ML means a slow search operation, the above-mentioned increase in the number of CAM cells wired in the OR-connection hinders a high-speed operation of the circuit as a whole.

### SUMMARY OF THE INVENTION

It is a general object of the present invention to provide an improved and useful associative memory circuit in which the above-mentioned problems are eliminated.

A more specific object of the present invention is to provide an associative memory circuit which can perform a fast search operation even with an increased number of memory cells connected to a match line.

In order to achieve the above-mentioned objects, there is provided according to one aspect of the present invention an associative memory circuit comprising:
a plurality of logic circuits connected to a common match line, each of the logic circuits comparing a content stored in each of a plurality of memory cells with externally supplied search data so as to output a comparison result thereof to the match line;
a reference-potential producing circuit provided correspondingly for the match line so as to produce a reference potential used in relation with the match line; and
a differential amplifier circuit performing a differential amplification to a potential of the match line and the reference potential so as to judge whether or not the content matches the search data.

According to the present invention, even when the number of memory cells connected to a match line is increased so as to augment the load of the match line and thus lower the transition rate thereof, a fast search operation can be performed.

Additionally, in the associative memory circuit according to the present invention, the reference-potential producing circuit may include trimming means varying the reference potential.

According to the present invention, an optimal reference potential can be produced in accordance with the number of memory cells connected to the match line. Thereby, a fast search operation can be performed.

Additionally, in the associative memory circuit according to the present invention, the reference-potential producing circuit may comprise serially connected first and second field-effect transistors provided with respective predetermined gate potentials.

According to the present invention, even when the power source voltage is low, the reference potential can be produced with a stable operation.

Additionally, in the associative memory circuit according to the present invention, the differential amplifier circuit may be laid out so as to correspond to a position at which each of the logic circuits is connected to the match line, and the reference-potential producing circuit may be provided correspondingly for the differential amplifier circuit so as to produce the reference potential used in the differential amplifier circuit.

According to the present invention, the reference potential can be supplied to the differential amplifier circuit via a short wiring so as to reduce a risk of noises mixing into the wiring.

In order to achieve the above-mentioned objects, there is also provided according to another aspect of the present invention an associative memory circuit comprising:
a plurality of logic circuits connected to a common match line, each of the logic circuits comparing a content stored in each of a plurality of memory cells with externally supplied search data so as to output a comparison result thereof to the match line, and the match line being discharged by at least one of the memory cells storing the content not matching the search data according to the comparison result after the match line is precharged;
a dummy cell discharging a first current from a precharged dummy match line, the first current being substantially a half of a second current discharged from the match line by one of the memory cells storing the content not matching the search data according to the comparison result;
a current sense unit detecting the first current and the second current so as to output respective detection potentials thereof; and
a differential amplifier circuit performing a differential amplification to the detection potentials so as to judge whether or not the content matches the search data.

According to the present invention, even when the number of memory cells connected to a match line is increased so as to augment the load of the match line and thus lower the transition rate thereof, a fast search operation can be performed. In addition, since the associative memory circuit according to this aspect of the present invention does not require the reference-potential producing circuit, the associative memory circuit can operate stably.

Other objects, features and advantages of the present invention will become more apparent from the following detailed description when read in conjunction with the accompanying drawings.

### BRIEF DESCRIPTION OF THE DRAWINGS

FIG.1 is a circuit diagram of a CAM (Content Addressable Memory) cell;
FIG.2 shows a truth table of the CAM cell shown in FIG.1 ;
FIG.3 is a circuit diagram of a conventional associative memory circuit;
FIG.4 shows signal waveforms of the conventional associative memory circuit shown in FIG.3;
FIG.5 is a circuit diagram of an associative memory circuit according to an embodiment of the present invention;
FIG.6 shows signal waveforms of the associative memory circuit shown in FIG.5;
FIG.7 is a circuit diagram of an embodiment of a differential amplifier circuit shown in FIG.5;
FIG.8 is a circuit diagram of an embodiment of a reference-potential producing circuit shown in FIG.5;
FIG.9 is a circuit diagram of the reference-potential producing circuit including a trimming means;
FIG.10 is a circuit diagram of an associative memory circuit according to another embodiment of the present invention; and
FIG.11 shows signal waveforms of the associative memory circuit shown in FIG.10.

### DETAILED DESCRIPTION OF THE PREFERRED EMBODIMENTS

A description will now be given, with reference to the drawings, of embodiments according to the present invention.

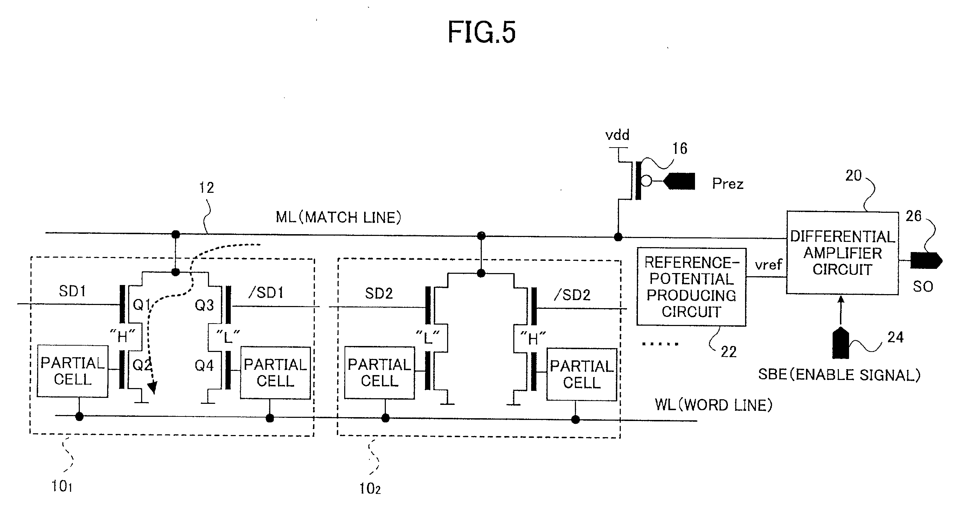

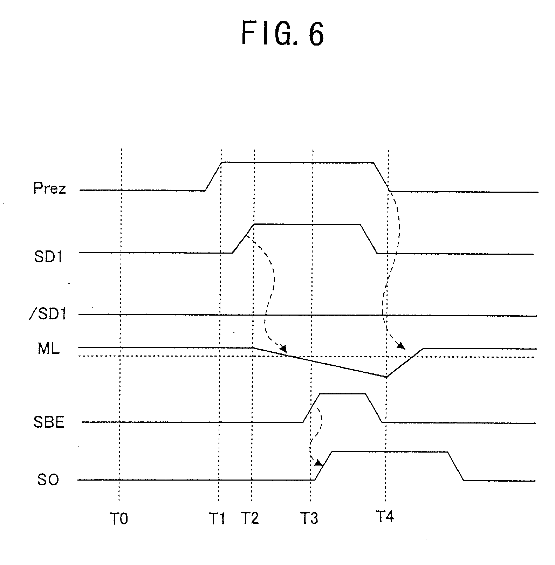

FIG.5 is a circuit diagram of an associative memory circuit according to an embodiment of the present invention. FIG.6 shows signal waveforms at parts of the associative memory circuit shown in FIG.5. Elements in FIG.5 that are identical or equivalent to the elements shown in FIG.3 are referenced by the same reference marks. In FIG.5, each of the CAM cells 10₁, 10₂, ..., surrounded by broken lines, has the structure shown in FIG.1. These CAM cells 10₁, 10₂, ... are wired in an OR-connection by the ML (Match Line) 12. A P-channel FET (Field-Effect Transistor) 16 used for precharging is connected to the ML 12. One input terminal of a differential amplifier circuit 20 is also connected to the ML 12.

A reference potential vref is supplied from a reference-potential producing circuit 22 to the other input terminal of the differential amplifier circuit 20. The differential amplifier circuit 20 operates, with an enable signal SBE being supplied from a terminal 24, so as to output a detection signal SO via a terminal 26.

As indicated by the signal waveforms shown in FIG.6, in a standby state at a time T0, a precharge signal (Prez) is "L" so that the ML 12 is charged with "H". A search operation begins by a precharge cancellation at a time T1. At the time T1, the precharge signal Prez transits to "H" so that the ML 12 becomes "H" in a floating state. Thereby, the precharge of the ML is cancelled.

Thereafter, search (key) data SDn, /SDn (n: an integer) is supplied to the CAM cells 10₁, 10₂, ... (at a time T2), and the search data is compared with data stored in each of the CAM cells so as to detect whether or not the search data matches the data stored in the CAM cell. Supposing that the search data of one bit matches the data stored in the CAM cell, the electric charge of the ML 12 is discharged from the CAM cell 10₁.

Connecting a multitude of the CAM cells to the ML 12 increases the load of the ML. Accordingly, it takes a long time to discharge an electric charge by one CAM cell. This hinders a high-speed search operation. In order that one CAM cell can sufficiently discharge the electric charge, capabilities of the FETs Q1 to Q4 of the CAM cell may be enhanced, as one solution. However, there is a limit in enhancing the capabilities of the FETs Q1 to Q4, since the CAM cell needs to be made smaller in size so as to decrease an entire chip area. Thereupon, the present invention utilizes the differential amplifier circuit 20 which can detect a small potential difference.

The differential amplifier circuit 20 is activated by the strobe (enable) signal SBE (at a time T3). The differential amplifier circuit 20 compares a level of the ML 12 with the reference potential vref so as to output a comparison result as the output data (detection signal) SO. The differential amplifier circuit 20 includes a latch circuit so as to latch the output data SO. Therefore, the strobe signal SBE is disabled as soon as the output data SO is latched. Thereafter, at a time T4, when the precharge signal Prez becomes "L" so that the ML 12 is precharged.

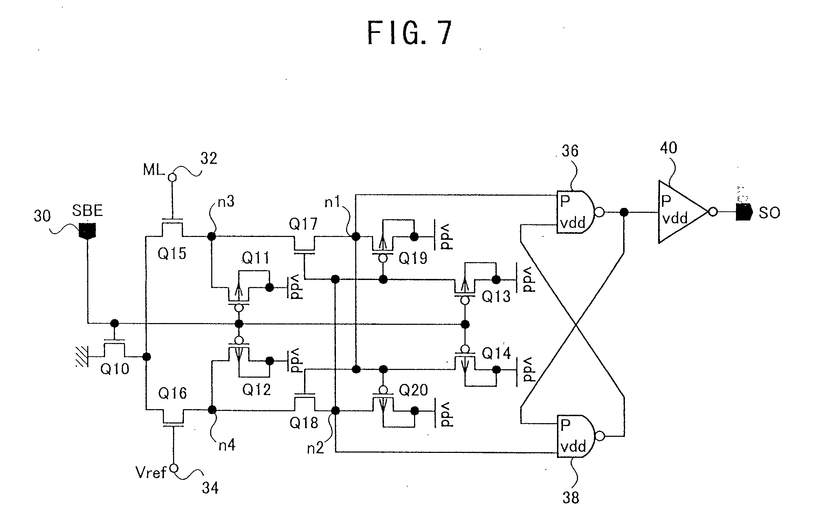

FIG.7 is a circuit diagram of an embodiment of the differential amplifier circuit 20. In FIG.7, the strobe signal SBE is supplied to a terminal 30. A gate of an N-channel FET Q10 and gates of P-channel FETs Q11 to Q14 are connected to the terminal 30. A source of the FET Q10 is connected to a power source vdd. A drain of the FET Q10 is connected to sources of N-channel FETs Q15 and Q16. A gate of the FET Q15 is connected to the ML 12 via a terminal 32. A gate of the FET Q16 is supplied with the reference potential vref via a terminal 34.

A source of the FET Q11 is connected to a power source vdd. A drain of the FET Q11 is connected to a node n3 between a drain of the FET Q15 and a source of an N-channel FET Q17. A source of the FET Q12 is connected to a power source vdd. A drain of the FET Q12 is connected to a node n4 between a drain of the FET Q16 and a source of an N-channel FET Q18.

A source of the FET Q13 is connected to a power source vdd. A drain of the FET Q13 is connected to a gate of the FET Q17 and a gate of a P-channel FET Q19. The drain of the FET Q13 is also connected to a node n2 between a drain of the FET Q18 and a drain of a P-channel FET Q20. The drain of the FET Q13 is also connected to an input terminal of a NAND gate 38. A source of the FET Q14 is connected to a power source vdd. A drain of the FET Q14 is connected to the gate of the FET Q17 and a gate of the FET Q20. The drain of the FET Q14 is also connected to a node n1 between a drain of the FET Q17 and a drain of the FET Q19. The drain of the FET Q14 is also connected to an input terminal of a NAND gate 36.

The NAND gates 36 and 38 form a flip-flop by connecting respective output terminals to input terminals of each other. An output of the NAND gate 36 is inverted by an inverter 40, and is output as the output data SO.

In a standby state where the signal SBE is "L", the nodes n1, n2, n3 and n4 are clamped in an "H" state. The signal SBE becomes "H" so that the differential amplifier circuit 20 is activated. Thereupon, a difference in levels between the gate of the FET Q15 connected to the ML 12 and the gate of the FET Q16 supplied with the reference potential vref creates a difference in transistor capabilities so as to cause a potential difference between the nodes n3 and n4. This potential difference is accepted by a latch comprising the FETs Q17 and Q19 and a latch comprising the FETs Q18 and Q20, and is binarized and latched by the above-mentioned flip-flop so as to generate the output data SO. The above-described structure can detect a small potential difference so as to create the output data SO.

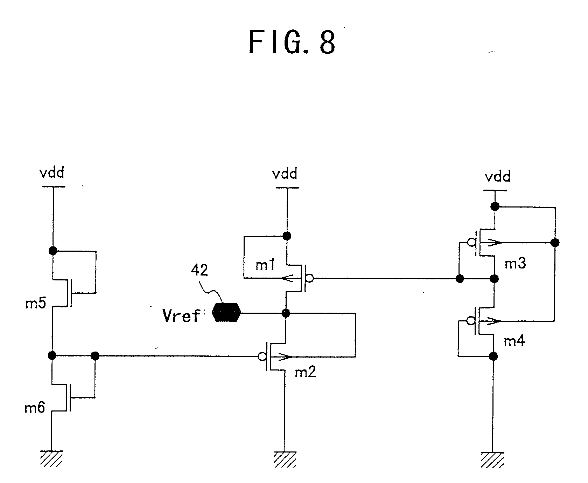

FIG.8 is a circuit diagram of an embodiment of the reference-potential producing circuit 22. In FIG.8, a source and a back gate of a P-channel FET m1 are connected to a power source vdd. A drain of the FET m1 is connected to a source and a back gate of a P-channel FET m2. The drain of the FET m1 is also connected to an output terminal 42. A drain of the FET m2 is connected to a power source vss. The FET m1 and the FET m2 compose a vref level producing unit.

A source and a back gate of a P-channel FET m3 are connected to a power source vdd. A drain and a gate of the FET m3 are connected to a gate of the FET m1 and a source of a P-channel FET m4. A drain and a gate of the FET m4 are connected to a power source vss. A back gate of the FET m4 is connected to a power source vdd. The FET m3 and the FET m4 compose a first gate level producing unit. The FET m4 operates as a load for the FET m3 so that a potential lowered from the power source vdd by a threshold level vth3 of the FET m3 is applied to the gate of the FET m1.

A drain and a back gate of an N-channel FET m5 are connected to a power source vdd. A source of the FET m5 is connected to a gate of the FET m2 and a drain and a gate of an N-channel FET m6. A source and the gate of the FET m6 are connected to a power source vss. The FET m5 and the FET m6 compose a second gate level producing unit. The FET m5 operates as a load for the FET m6 so that a potential raised from a level of the power source vss by a threshold level vth6 of the FET m6 is applied to the gate of the FET m2.

Accordingly, the serially-connected FETs m1 and m2 of the vref level producing unit divide the potential of the power source vdd with on-state resistances corresponding to the respective gate potentials on the basis of the level of the power source vss, and outputs the divided potential of the power source vdd as the reference potential vref via the terminal 42. That is, even when the power source voltage vdd is so low that a relational expression of vth3+vth6>vdd stands, the FETs m1 and m2 can perform a stable transistor operation so as to produce the reference potential vref.

Anther advantage of the above-described simple structure of the reference-potential producing circuit 22 is as follows. As shown in FIG.5, the ML (Match Line) 12 runs parallel with a WL (Word Line),between which the CAM cells are arranged at intervals. A plurality of the differential amplifier circuits 20 are arranged also between the ML and the WL at a cell pitch, i.e., at the same intervals as the CAM cells. On the other hand, the reference-potential producing circuit 22 may be provided, one in the entire chip. However, since a CAM characteristically consumes plenty of electric current, drawing around the output (the reference potential vref) of the one reference-potential producing circuit 22 to the plurality of the differential amplifier circuits 20 in the entire chip increases a risk of noises mixing into the drawn-around wiring. Therefore, it is preferable that the reference-potential producing circuit 22 be provided, one to one, for each of the differential amplifier circuits 20. In this respect, the reference-potential producing circuit 22 is preferable since the reference-potential producing circuit 22 has the simple structure as shown in FIG.8, which accounts for only a small circuit-containing area.

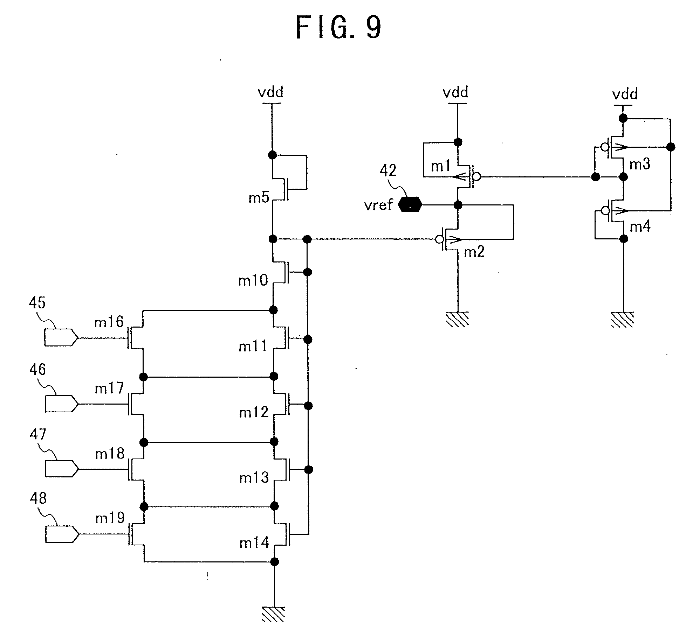

Further, since the structure shown in FIG.8 produces the reference potential vref by controlling the gate potentials of the serially-connected two-stage FETs m1 and m2, a trimming method can also be achieved by varying gate levels of the FETs m1 and m2, so as to facilitate changes of levels. FIG.9 is a circuit diagram of the reference-potential producing circuit 22 including a trimming means.

In FIG.9, elements that are identical or equivalent to the elements shown in FIG.8 are referenced by the same reference marks. Serially connected FETs m10, m11, m12, m13 and m14 are provided in place of the FET m6. A drain of the FET m10 is connected to the source of the FET m5. A source of the FET m14 is connected to the power source vss. Gates of the FETs m10, m11, m12, m13 and m14 are commonly connected to the gate of the FET m2.

In addition, drains and sources of serially connected FETs m16, m17 m18 and m19 are connected to corresponding drains and sources of the FETs m11, m12, m13 and m14. Gates of the FETs m16, m17 m18 and m19 are connected to terminals 45, 46, 47 and 48, respectively.

In this structure, when signals of "H" are supplied to the terminals 45, 46, 47 and 48, the FETs m16, m17, m18 and m19 turn on. Thereby, a source of the FET m10 is connected to the power source vss so that a threshold level of the FET m10 is supplied to the gate of the FET m2. When the signals of "H" are supplied to the terminals 46, 47 and 48, the FETs m17, m18 and m19 turn on. Thereby, the source of the FET m11 is connected to the power source vss so that a total of threshold levels of the FETs m10 and m11 is supplied to the gate of the FET m2.

Besides, the gate level of the FET m1 may be varied in the same manner as described with reference to FIG.9 in which the gate level of the FET m2 is varied.

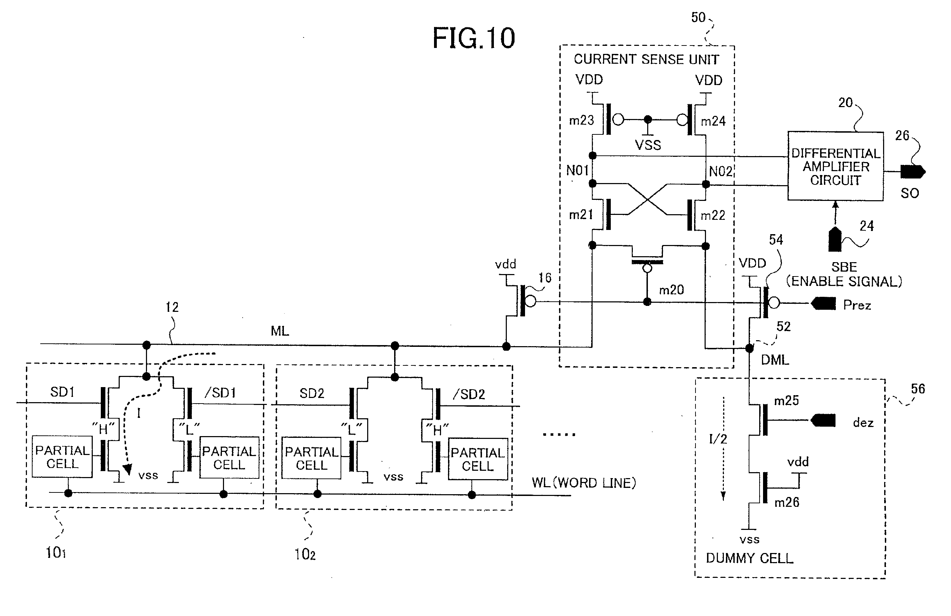

FIG.10 is a circuit diagram of an associative memory circuit according to another embodiment of the present invention. FIG.1 shows signal waveforms at parts of the associative memory circuit shown in FIG.10. For the purpose of providing a smaller layout and restricting a power consumption, the associative memory circuit comprises a current sense unit at a stage preceding the differential amplifier circuit 20, in which an output of the current sense unit is supplied to the differential amplifier circuit 20. Elements in FIG.10 that are identical or equivalent to the elements shown in FIG.5 are referenced by the same reference marks.

In FIG.10, each of the CAM cells 10₁, 10₂, ..., surrounded by broken lines, has the structure shown in FIG.1. These CAM cells 10₁, 10₂, ... are wired in an OR-connection by the ML 12. The P-channel FET 16 used for precharging is connected to the ML 12. A source of an N-channel FET m21 of a current sense unit 50 is also connected to the ML 12.

The current sense unit 50 comprises the N-channel FET m21, an N-channel FET m22, P-channel FETs m20, m23 and m24. A gate of the FET m20 is supplied with the precharge signal (Prez). A source and a drain of the FET m20 are connected to the source of the FET m21 and a source of the FET m22, respectively. The source of the FET m22 is connected to a DML (Dummy Match Line) 52. A gate of the FET m21 is connected to drains of the FETs m22 and m24 and the one input terminal of the differential amplifier circuit 20. A gate of the FET m22 is connected to drains of the FETs m21 and m23 and the other input terminal of the differential amplifier circuit 20. Gates of the FETs m23 and m24 are supplied with a power source vss, and sources of the FETs m23 and m24 are supplied with a power source vdd. In the current sense unit 50, due to voltage drops in the FETs m23 and m24 corresponding to source currents of the FETs m21 and m22, potentials of nodes N01 and N02 vary, the nodes N01 and N02 being the drains of the FETs m21 and m22, respectively.

A P-channel FET 54 used for precharging is connected to the DML 52. A drain of an N-channel FET m25 of a dummy cell 56 is also connected to the DML 52. A gate of the FET m25 is supplied with a signal dez. A source of the FET m25 is connected to a drain of an N-channel FET m26. A gate of the FET m26 is supplied with a power source vdd, and a source of the FET m26 is connected to a power source vss. The dummy cell 56 is so set as to discharge substantially a half (I/2) of a current I which a CAM cell of one bit (e.g., the CAM cell 10₁) discharges when search data does not match data stored in the CAM cell.

The differential amplifier circuit 20 operates, with the enable signal SBE being supplied from the terminal 24. The differential amplifier circuit 20 performs a differential amplification to the potentials of the nodes N01 and N02 which are the drains of the FETs m21 and m22, respectively, of the current sense unit 50 so as to output the detection signal SO via the terminal 26.

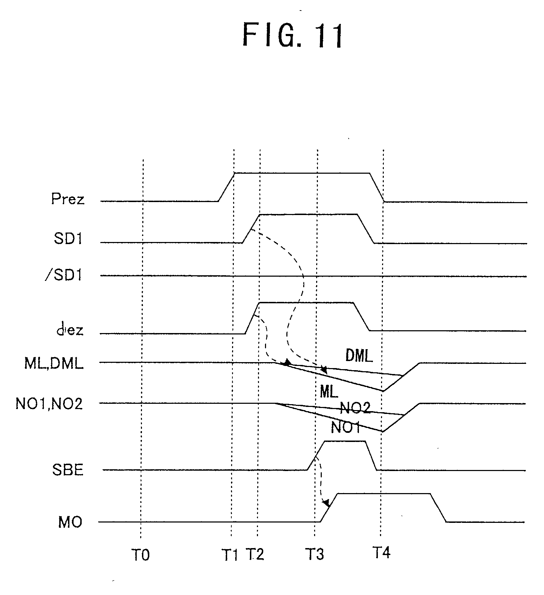

As indicated by the signal waveforms shown in FIG.11, in a standby state at a time T0, the precharge signal (Prez) is "L" so that the ML 12 and the DML 52 are precharged with "H". Then, when a search operation begins, the precharge signal Prez transits to "H" so that the precharge of the ML and the DML is cancelled (at a time T1).

Thereafter, at a time T2, search data SD transits to "H" so that the search data is compared with data stored in the CAM cell. In this example, the search data is supposed not to match data stored in a CAM cell of one bit. At the same time as this operation, the signal dez controlling the dummy cell 56 also transits to "H". Thereby, electric charges are discharged from the ML 12 and the DML 52 so that the levels of the ML 12 and the DML 52 become lower. Similarly, the levels of the nodes N01 and N02 in the current sense unit 50 also fall.

At this point, since the dummy cell 56 is capable of discharging substantially half (1/2) the current that one CAM cell discharges, the level of the DML 52 falls slower than the level of the ML 12. In the current sense unit 50, according to a current value of the FET m21 connected to the CAM cells 10₁, 10₂, ... and a current value of the FET m22 connected to the dummy cell 56, a difference occurs between the levels of the nodes N01 and N02. Thereafter, at a time T3, the enable signal SBE supplied from the terminal 24 is turned to "H" so as to activate the differential amplifier circuit 20. The differential amplifier circuit 20 amplifies the potential difference between the nodes N01 and N02, and outputs the amplified potential difference via the terminal 26. The above-described structure according to the present embodiment enables the detection result SO to be output at a high speed before a sufficient potential difference occurs between the ML 12 and the DML 52. Further, since the present embodiment does not employ the reference-potential producing circuit 22, the associative memory circuit according to the present embodiment can operate stably.

Besides, the CAM cells 10₁, 10₂, ... correspond to memory cells. The FETs Q1 to Q4 correspond to logic circuits. The FETs m16 to m19 correspond to trimming means. The FETs m1 and m2 correspond to first and second field-effect transistors.

The present invention is not limited to the specifically disclosed embodiments, and variations and modifications may be made without departing from the scope of the present invention.

The present application is based on Japanese priority application No. 2001-290891 filed on September 25, 2001, the entire contents of which are hereby incorporated by reference.

## Claims

1. An associative memory circuit comprising a plurality of logic circuits connected to a common match line (12), each of the logic circuits (Q1-Q4) comparing a content stored in each of a plurality of memory cells (10₁, 10₂, ...) with externally supplied search data so as to output a comparison result thereof to said match line (12),
**characterized by** further comprising:
a reference-potential producing circuit (22) provided correspondingly for said match line (12) so as to produce a reference potential used in relation with said match line (12) ; and
a differential amplifier circuit (20) performing a differential amplification to a potential of said match line (12) and said reference potential so as to judge whether or not said content matches said search data.

2. The associative memory circuit as claimed in claim 1, **characterized in that** said reference-potential producing circuit (22) includes trimming means (m16-m19) varying said reference potential.

3. The associative memory circuit as claimed in claim 1, **characterized in that** said reference-potential producing circuit (22) is laid out so as to correspond to a position at which each of said logic circuits (Q1-Q4) is connected to said match line (12).

4. The associative memory circuit as claimed in claim 1, **characterized in that** said match line (12) is discharged by at least one of said memory cells (10₁, 10₂, ...) storing the content not matching said search data according to said comparison result, after said match line (12) is precharged.

5. The associative memory circuit as claimed in claim 1, **characterized in that** said reference-potential producing circuit (22) comprises serially connected first and second field-effect transistors (m1, m2) provided with respective predetermined gate potentials.

6. The associative memory circuit as claimed in claim 2, **characterized in that** said reference-potential producing circuit (22) comprises serially connected first and second field-effect transistors (m1, m2) provided with respective predetermined gate potentials.

7. The associative memory circuit as claimed in claim 6, **characterized in that** said trimming means (m16-m19) varies at least one of said gate potentials of said first and second field-effect transistors (m1, m2).

8. The associative memory circuit as claimed in claim 2, **characterized in that** said differential amplifier circuit (20) is laid out so as to correspond to a position at which each of said logic circuits (Q1-Q4) is connected to said match line (12), and said reference-potential producing circuit (22) is provided correspondingly for said differential amplifier circuit (20) so as to produce said reference potential used in said differential amplifier circuit (20).

9. The associative memory circuit as claimed in claim 3, **characterized in that** said differential amplifier circuit (20) is laid out so as to correspond to the position at which each of said logic circuits (Q1-Q4) is connected to said match line (12), and said reference-potential producing circuit (22) is provided correspondingly for said differential amplifier circuit (20) so as to produce said reference potential used in said differential amplifier circuit (20).

10. The associative memory circuit as claimed in claim 5, **characterized in that** said differential amplifier circuit (20) is laid out so as to correspond to a position at which each of said logic circuits (Q1-Q4) is connected to said match line (12), and said reference-potential producing circuit (22) is provided correspondingly for said differential amplifier circuit (20) so as to produce said reference potential used in said differential amplifier circuit (20).

11. The associative memory circuit as claimed in claim 6, **characterized in that** said differential amplifier circuit (20) is laid out so as to correspond to a position at which each of said logic circuits (Q1-Q4) is connected to said match line (12), and said reference-potential producing circuit (22) is provided correspondingly for said differential amplifier circuit (20) so as to produce said reference potential used in said differential amplifier circuit (20).

12. The associative memory circuit as claimed in claim 7, **characterized in that** said differential amplifier circuit (20) is laid out so as to correspond to a position at which each of said logic circuits (Q1-Q4) is connected to said match line (12), and said reference-potential producing circuit (22) is provided correspondingly for said differential amplifier circuit (20) so as to produce said reference potential used in said differential amplifier circuit (20).

13. An associative memory circuit comprising a plurality of logic circuits connected to a common match line (12), each of the logic circuits (Q1-Q4) comparing a content stored in each of a plurality of memory cells (10₁, 10₂, ...) with externally supplied search data so as to output a comparison result thereof to said match line (12), and the match line (12) being discharged by at least one of said memory cells (10₁, 10₂, ...) storing the content not matching said search data according to said comparison result after said match line (12) is precharged,
**characterized by** further comprising:
a dummy cell (56) discharging a first current from a precharged dummy match line (52), the first current being substantially a half of a second current discharged from said match line (12) by one of said memory cells (10₁, 10₂, ...) storing the content not matching said search data according to said comparison result;
a current sense unit (50) detecting said first current and said second current so as to output respective detection potentials thereof; and
a differential amplifier circuit (20) performing a differential amplification to said detection potentials so as to judge whether or not said content matches said search data.
